# EUROPÄISCHE PATENTSCHRIFT

(11) **EP 3 155 331 B1**
(45) Veröffentlichungstag und Bekanntmachung des Hinweises auf die Patenterteilung: **02.09.2020**
(21) Anmeldenummer: 15730688.7
(22) Anmeldetag: 11.06.2015
(51) Int. Cl.: F25B 21/02

(54) **KÜHL- UND/ODER GEFRIERGERÄT MIT EINEM VAKUUMDÄMMKÖRPER VERSEHEN MIT EINEM THERMOELEKTRISCHEN ELEMENT**
REFRIGERATION AND/OR FREEZER DEVICE COMPRISING A VACUUM INSULATION BODY WITH A THERMO-ELECTRIC ELEMENT
APPAREIL DE RÉFRIGÉRATION ET/OU DE CONGÉLATION DOTÉ D'UN CORPS D'ISOLATION À VIDE COMPRENANT UN ELEMENT THERMOÉLECTRIQUE

(30) Priorität: 16.06.2014 DE 102014008668; 20.01.2015 DE 102015000553; 29.01.2015 DE 102015001060; 29.01.2015 DE 102015001142; 02.02.2015 DE 102015001281; 03.02.2015 DE 102015001380; 20.05.2015 DE 102015006561
(43) Veröffentlichungstag der Anmeldung: 19.04.2017
(73) Patentinhaber: Liebherr-Hausgeräte Lienz GmbH, 9900 Lienz (AT); Liebherr-Hausgeräte Ochsenhausen GmbH, 88416 Ochsenhausen (DE)
(72) Erfinder: KERSTNER, Martin, 97072 Würzburg (DE); FREITAG, Michael, 97082 Würzburg (DE); HIEMEYER, Jochen, 97753 Karlstadt (DE)
(74) Vertreter: Herrmann, Uwe
(86) Internationale Anmeldenummer: PCT/EP2015/001183
(87) Internationale Veröffentlichungsnummer: WO 2015/192951

(56) Entgegenhaltungen:
- EP-A1- 0 860 669
- EP-A2- 0 592 044
- DE-A1- 4 142 842
- DE-B- 1 113 222
- GB-A- 2 331 838
- US-A- 5 653 111
- US-A- 5 715 684

## Beschreibung

Die vorliegende Erfindung betrifft ein Kühl- und/oder Gefriergerät umfassend einen Vakuumdämmkörper mit einem als Peltierelement ausgebildeten thermoelektrischen Element. Bei Kühl- und/oder Gefriergeräten wird in dem Bereich zwischen dem Außenmantel des Gerätes und dem zu kühlenden Innenbehälter ein Vakuumdämmkörper angeordnet, um mittels des Prinzips der Vakuumwärmedämmung zwischen Außen- und Innenseite des zu dämmenden Geräts eine ausreichend hohe Wärmedämmung zu erreichen. Ein solches Kühl- und/oder Gefriergerät ist zum Beispiel im Dokument GB2331838A offenbart. Thermoelektrische Elemente, insbesondere Peltierelemente, sind Elemente, die mit Hilfe von elektrischer Energie ein Temperaturgefälle erzeugen können. Das Peltierelement besteht aus zwei oder mehreren kleinen Quadern, die aus p- und n-dotiertem Halbleitermaterial aufgebaut sind und alternierend oben und unten durch metallische Brücken miteinander verbunden sind. Die Quader sind so miteinander verbunden, dass eine Reihenschaltung entsteht, bei der verschieden dotierte Halbleitermaterialien abwechselnd angeordnet sind.

Die thermoelektrischen Elemente weisen jedoch einen vergleichsweise geringen Wirkungsgrad bzw. eine geringe Leistung auf, was dazu führt, dass PeltierElemente bei der Kühlung von Kühl- und/oder Gefriergeräten keine weitreichende Verbreitung finden. Lediglich im Bereich von Kühlboxen, in denen keine große Temperaturdifferenz benötigt wird, finden thermoelektrische Elemente vereinzelt Anwendung. Daher beschränkt sich die Verwendung von thermoelektrischen Elementen im Bereich der Kühltechnik auf Spezialfälle.

Aufgrund der jedoch immer besser werdenden Dämmung und der sich hieraus ergebenden verminderten Kühlleistung, die zur Kühlung benötigt wird, werden thermoelektrische Elemente, insbesondere Peltierelemente zu einer interessanten Alternative.

Bei einer gleichzeitigen Verwendung einer Vakuumdämmung und eines thermoelektrischen Elements entsteht aber das Problem, die beiden Bauteile wirkungsvoll zu integrieren. Diese Problematik rührt daher, dass die Kälte- und Wärmeerzeugung eines thermoelektrischen Elements naturgemäß unmittelbar nebeneinander stattfinden, sodass die Verwendung des thermoelektrischen Elements nur mit Hilfe eines großen Durchbruchs durch die Vakuumdämmung vorgenommen werden kann. Dies führt zu einer verminderten Dämmleistung und einem komplizierten Aufbau von Vakuumdämmung und thermoelektrischen Element.

Diese Überlegungen sind aber keineswegs auf Kühl- und/oder Gefriergeräte beschränkt sondern gelten für wärmeisolierte Behältnisse im Allgemeinen. Wärmeisolierte Behältnisse, die diesen Überlegungen unterliegen, weisen mindestens einen temperierten Innenraum auf, wobei dieser gekühlt oder beheizt sein kann, so dass sich in dem Innenraum eine Temperatur unterhalb oder oberhalb der Umgebungstemperatur von z.B. 21 °C ergibt.

Aufgabe der vorliegenden Erfindung ist es, die vorstehende Problematik zu beheben und eine effiziente Verwendung einer Kombination aus thermoelektrischen Element und Vakuumdämmung zu schaffen, die vergleichsweise einfach aufgebaut ist.

Die vorliegende Erfindung ist offenbart im unabhängigen Anspruch 1. Weitere Ausführungsbeispiele sind in den abhängigen Ansprüchen offenbart.

Um einen Vakuumdämmkörper bereitzustellen, in dem Vakuum herrscht, ist eine vorzugsweise diffusionsdichte Umhüllung bzw. Folie notwendig. Dabei kann in dem Vakuumbereich ein Kernmaterial vorgesehen sein, das dem Vakuumdämmkörper die entsprechende Formstabilität verleiht und gleichzeitig verhindert, dass nach Erzeugen eines Vakuums die Wandungen der Umhüllung unmittelbar aneinander anliegen.

Dadurch, dass das thermoelektrische Element im Vakuumbereich vorgesehen ist, wird die üblicherweise große Durchbrechung der Vakuumdämmung vermieden, die herkömmlicherweise bei der Kühlung durch ein thermoelektrisches Element vorgesehen war. Durch diese Anordnung ergeben sich eine besonders vorteilhafte Dämmleistung eines mittels des Vakuumdämmkörpers begrenzten Innenraums sowie eine sehr platzsparende und strukturierte Anordnung der beiden Bauteile.

Die Anordnung des thermoelektrischen Elements in dem Vakuumbereich sorgt dafür, dass bei einem Betreiben des thermoelektrischen Elements an der Außenseite der Umhüllung ein zur Orientierung des thermoelektrischen Elements entsprechender Temperaturgradient vorhanden ist. Das bedeutet, dass je nach Ausrichtung der warmen bzw. der kalten Fläche des thermoelektrischen Elements die der warmen bzw. der kalten Fläche zugewandten Bereiche der Umhüllung eine entsprechende Temperatur annehmen. Demnach herrschen an zwei verschiedenen Stellen (Bereiche) der Außenseite der Umhüllung zwei verschiedene Temperaturniveaus, die durch das thermoelektrische Element hervorgerufen werden bzw. durch dieses hervorrufbar sind.

Die Anordnung des thermoelektrischen Elementes innerhalb des Vakuumbereichs bringt auch den Vorteil mit sich, dass diese vor äußeren Einflüssen geschützt ist. Insbesondere kann auf Versiegelungsmaßnahmen zum Verhindern von Kondensation am kalten Punkt des thermoelektrischen Elementes bzw. Peltierelementes verzichtet werden.

Vorzugsweise weist das thermoelektrische Element eine im Wesentlichen plattenartige Grundform auf, wobei das thermoelektrische Element zwei Thermoflächen aufweist, die vorzugsweise zueinander in etwa parallel verlaufen und voneinander beabstandet sind.

Nach der Erfindung weist der Vakuumdämmkörper zusätzlich zwei in dem Vakuumbereich angeordnete Wärmeleitkörper auf. Diese stehen in einem wärmeleitenden Kontakt mit dem Peltierelement und mit der Umhüllung. Die BerWärmeleitkörper ; stehen in unmittelbarem oder in mittelbarem Kontakt mit der Umhüllung.

Der genannte Wärmeleitkörper besitzt vorteilhafterweise eine Wärmeleitfähigkeit λ vom mindestens 3 W/(m*K). Vorzugsweise ist die Wärmeleitfähigkeit λ des Wärmeleitkörpers mindestens 10 W/(m*K), bevorzugterweise mindestens 75 W/(m*K), und besonders bevorzugt mindestens 150 W/(m*K).

Erfindungsgemäß ist es gewährleistet, das in dem Vakuumbereich angeordnete thermoelektrische Element in einem wirkungsvollen thermischen (direkten oder indirekten) Kontakt mit der Umhüllung zu bringen. Der Wärmeleitkörper sorgt dabei für eine gute thermische Kopplung von Peltierelement bzw. thermoelektrischem Element und Umhüllung, da der Wärmeaustausch via Konvektion in einem vakuumierten Bereich nur verlangsamt oder gar nicht möglich ist.

Bei einem Transport der an der Kälte- sowie der Abwärmefläche des thermoelektrischen Elements erzeugten bzw. entzogenen Wärme durch die Umhüllung des Vakuumdämmkörpers hindurch stellt die Umhüllung, unabhängig von ihrer Dicke, einen nennenswerten Wärmewiderstand dar, den es zu überwinden gilt.

Insofern ist es zweckmäßig, zusätzlich zum thermoelektrischen Element den Wärmeleitkörper (im Folgenden auch als "primärer Wärmetauscher" bezeichnet) so vorzusehen, dass seine Kontaktfläche zu der Umhüllung größer ist als seine Kontaktfläche zu dem thermoelektrischen Element. Dies führt dazu, dass die Übergangsfläche an der Umhüllung deutlich größer ist als die Übergangsfläche des thermoelektrischen Elements an den Wärmeleitkörper und die über die Umhüllung abfallende Temperatur auf ein vertretbares Maß reduziert wird. Die geringere Temperaturdifferenz, die auf den beiden Seiten der Umhüllung aufgrund der spezifischen Ausgestaltung des Wärmeleitkörpers herrscht, führt zu insgesamt geringeren Verlusten an der Umhüllung.

Die Wärmeleitkörper sind erfindungsgemäß innerhalb des Vakuumbereiches angeordnet.

Vorzugsweise erfolgt eine Fixierung des oder der thermoelektrischen Elemente und der Wärmeleitkörper, die innerhalb des Vakuumbereichs angebracht sind, mit Hilfe der Umhüllung selbst, die aufgrund ihres vakuumierten Zustands einen gewissen von außen anliegenden Druck aufweist, der zur Fixierung der im Vakuumbereich angeordneten Elemente genutzt werden kann. Durch das im Vakuumbereich vorhandene Vakuum entsteht ein Unterdruck, der ausreichend groß ausgebildet werden kann, um eine Schichtung des thermoelektrischen Elements mit dem Wärmeleitkörper zu erreichen, ohne dass die für einen Wärmeleitkörper übliche Kontaktierung oder Verklebung mit einer gut wärmeleitfähigen Substanz notwendig wäre. Es ist daher nicht notwendig ein weiteres Element zwischen Umhüllung und Peltierelement und/oder Wärmeleitkörper bzw. zwischen Umhüllung und Wärmeleitkörper vorzusehen, das die Wärmeleitfähigkeit vermindert.

Gemäß der Erfindung ist vorgesehen, dass das thermoelektrische Element zwischen den Festkörpern verspannt ist, die den primären Wärmetauscher bilden. Dabei ist vorzugsweise vorgesehen, dass die Verbindungselemente, die die Festkörper miteinander verbinden eine geringe Wärmeleitfähigkeit aufweisen, so dass keine signifikante Wärmebrücke entsteht. Denkbar ist es, als Verbindungselemente Schrauben einzusetzen. Auch ist es möglich, als Verbindungselemente ein Teil, wie z.B. ein Spritzgussteil zu verwenden, das an einem Formteil befestigt ist und bei der Montage an einem anderen Formteil einrastet.

In einer Ausführungsform ist vorgesehen, dass zwischen den Wärmeleitkörpern und der Innenseite der Folie kein Haftmittel vorgesehen ist.

Grundsätzlich ist von der Erfindung jedoch auch der Fall umfasst, dass zwischen dem thermoelektrischen Element und den Wärmeleitkörpern den Wärmeübergang fördernde Mittel, insbesondere eine wärmeleitfähige Substanz z.B. in Form einer Verklebung vorhanden sind.

In einer Ausführungsform ist vorgesehen, dass das thermoelektrische Element und die Wärmeleitkörper anhand einer Klebeverbindung miteinander verbunden werden. Vorzugsweise ist dabei vorgesehen, dass ein Kleber mit einer vergleichsweise hohen Wärmeleitfähigkeit verwendet wird, beispielsweise ein Kleber, in dessen Klebemasse gut wärmeleitende Füllstoffe vorhanden sind. Ein derartiger Kleber kann auch für andere im Rahmen der vorliegenden Erfindung thematisierte Klebeverbindungen verwendet werden.

Nach einem weiteren vorteilhaften, optionalen Merkmal der Erfindung weist der Vakuumdämmkörper ferner wenigstens einen Wärmetauscher (im Folgenden auch als "sekundärer Wärmetauscher" bezeichnet) auf, der außerhalb des Vakuumbereichs, also an der Außenseite der Umhüllung, angeordnet ist. Der sekundäre Wärmetauscher ist mit einem Bereich der Umhüllung thermisch gekoppelt, der vorzugsweise der Bereich ist, der durch das thermoelektrische Element in seiner Temperatur beeinflussbar ist. Thermisch gekoppelt umfasst die Möglichkeit eines direkten oder eines thermischen Kontakts.

Erfindungsgemäß ist vorgesehen, dass die Wärmeleitkörper mit der Innenseite der Folie verbunden sind und nicht im direkten Kontakt mit dem sekundären Wärmetauscher stehen. Die Wärmeübertragung erfolgt in diesem Fall durch die Folie hindurch. Diese Ausgestaltung kann aus fertigungstechnischen Gründen sowie aus Gründen der Vakuumdichtigkeit vorteilhaft sein. Denkbar ist, dass die Dicke der Folie im Berührungsbereich des oder der Wärmeleitkörper gegenüber den anderen Bereichen reduziert ist, um einen besseren Wärmetausch zu gewährleisten. Alternativ kann die Dicke der Folie aber auch in diesen Bereichen unverändert sein, was wiederum aus fertigungstechnischen Gründen sowie aus Gründen der Vakuumdichtigkeit vorteilhaft sein kann.

Der sekundäre Wärmetauscher kann z.B. mittels einer Wärmeleitpaste oder einem Wärmeleitkleber mit der äußeren Folienseite verbunden sein.

In einer bevorzugten Ausgestaltung ist vorgesehen, dass zur mechanischen Entlastung des thermoelektrischen Elements im Fertigungsprozess auf einer Seite eine dünne Graphitfolie als Kopplungselement angeordnet wird, wobei das thermoelektrischen Element durch Spannung zwischen den beiden Festkörpern über die Verbindungselemente fixiert wird. Auf der anderen Seite wird der Wärmeleitkleber verwendet, auch um Fertigungstoleranzen bei den Dicken von thermoelektrischem Element, Festkörpern und den Verbindungselementen auszugleichen. Vorzugsweise wird die Graphitfolie auf der Warmseite eingesetzt, da hier die höheren Wärmeströme fließen und der Wärmeübergangswiderstand durch die dünne Graphitfolie üblicherweise geringer ist als die durch Toleranzausgleich etwas dickere Wärmeleitkleberschicht.

Vorzugsweise sind der oder die sekundären Wärmetauscher so angeordnet, dass ein mittelbarer Wärmeübergang von oder zu den primären Wärmetauschern erfolgt. Vorzugsweise umfasst die Umhüllung eine Hochbarrierefolie oder ist eine Hochbarrierefolie, die den durch die Umhüllung gebildeten Vakuumbereich vakuumdicht abschließt.

Unter einer vakuumdichten oder diffusionsdichten Umhüllung bzw. unter einer vakuumdichten oder diffusionsdichten Verbindung bzw. unter dem Begriff Hochbarrierefolie wird vorzugsweise eine Umhüllung bzw. eine Verbindung bzw. eine Folie verstanden, mittels derer der Gaseintrag in den Vakuumdämmkörper so stark reduziert ist, dass der durch Gaseintrag bedingte Anstieg in der Wärmeleitfähigkeit des Vakuumdämmkörpers über dessen Lebensdauer hinweg ausreichend gering ist. Als Lebensdauer ist beispielsweise ein Zeitraum von 15 Jahren, vorzugsweise von 20 Jahren und besonders bevorzugt von 30 Jahren anzusetzen. Vorzugsweise liegt der durch Gaseintrag bedingte Anstieg in der Wärmeleitfähigkeit des Vakuumdämmkörpers über dessen Lebensdauer bei < 100 % und besonders bevorzugt bei < 50 %.

Vorzugsweise ist die flächenspezifische Gasdurchgangsrate der Umhüllung bzw. der Verbindung bzw. der Hochbarrierefolie < 10-5 mbar * l / s * m² und besonders bevorzugt < 10-6 mbar * l / s * m² (gemessen nach ASTM D-3985). Diese Gasdurchgangsrate gilt für Stickstoff und Sauerstoff. Für andere Gassorten (insbesondere Wasserdampf) bestehen ebenfalls niedrige Gasdurchgangsraten vorzugweise im Bereich von < 10-2 mbar * l / s * m² und besonders bevorzugt im Bereich von < 10-3 mbar * l / s * m² (gemessen nach ASTM F-1249-90). Vorzugsweise werden durch diese geringen Gasdurchgangsraten die vorgenannten geringen Anstiege der Wärmeleitfähigkeit erreicht.

Ein aus dem Bereich der Vakuumpaneele bekanntes Hüllsystem sind sogenannte Hochbarrierefolien. Darunter werden im Rahmen der vorliegenden Erfindung vorzugsweise Ein- oder Mehrschichtfolien (die vorzugsweise siegelfähig sind) mit einer oder mehreren Barriereschichten (typischerweise metallische Schichten oder Oxid-Schichten, wobei als Metall oder Oxid vorzugsweise Aluminium bzw. ein Aluminiumoxid Verwendung findet) verstanden, die den oben genannten Anforderungen (Anstieg der Wärmeleitfähigkeit und/oder flächenspezifische Gasdurchgangsrate) als Barriere gegen den Gaseintrag genügen.

Bei den oben genannten Werten bzw. bei dem Aufbau der Hochbarrierefolie handelt es sich um exemplarische, bevorzugte Angaben, die die Erfindung nicht beschränken.

Vorzugsweise umfasst der erfindungsgemäße Vakuumdämmkörper ferner ein innerhalb des Vakuumbereichs vorhandenes Kernmaterial, das zwischen dem einzelnen Halbleiterelementen des thermoelektrischen Elements angeordnet ist.

Dem Fachmann ist bekannt, dass ein thermoelektrisches Element (Peltier-Element) aus mehreren rasterartig nebeneinander angeordneten unterschiedlich dotierten Halbleiterelementen besteht. Hierbei sind die jeweiligen Halbleiterelemente voneinander beabstandet, wobei nach einem optionalen Merkmal dieser Erfindung ein Kernmaterial in diesem Bereich vorgesehen ist.

Das Kernmaterial wird also in dem Bereich zwischen den Halbleiter-Pellets des Peltier-Elements eingefügt. Dadurch wird die Gaswärmeleitung als auch der Strahlungswärmeaustausch, der in einem vakuumierten Zustand mit steigender Reinheit des Vakuums in seiner Bedeutung bei der Übertragung von Temperatur zunimmt, zwischen warmer und kalter Seite des thermoelektrischen Elements wirkungsvoll unterbunden. Insgesamt führt dies zu einer Leistungssteigerung des thermoelektrischen Elements, wodurch ein ressourceneffizienteres Kühlen bzw. Wärmen möglich ist.

Zudem beschreibt die vorliegende Erfindung ein thermoelektrisches Element, das mindestens ein n-dotiertes Halbleiterelement, und mindestens ein p-dotiertes Halbleiterelement umfasst. Das p-dotierte Halbleiterelement ist über eine Leiterbrücke mit dem n-dotierten Halbleiterelement verbunden, wobei die beiden Halbleiterelemente voneinander beabstandet sind, so dass zwischen ihnen ein Freiraum gebildet ist. Das erfindungsgemäße thermoelektrische Element zeichnet sich dadurch aus, dass der Freiraum zwischen dem p-dotierten Halbleiterelement und dem n-dotierten Halbleiterelement mit einem Material in Pulverform gefüllt ist.

Vorzugsweise weist das Material in Pulverform eine mittlere Korngröße auf, bei der ein Pulverkorns zwischen 5 µm und 30 µm, vorzugsweise zwischen 10 µm und 25 µm, und besonders bevorzugt zwischen 15 µm und 20 µm, liegt.

Eine andere Bezeichnung für die unterschiedlich dotierten Halbleiterelemente des thermoelektrischen Elements sind Halbleiter-Pellets. Das zwischen den Raum der Halbleiter-Pellets eingefügte Material in Pulverform verhindert eine Konvektion zwischen der Wärmefläche und der Kühlfläche des thermoelektrischen Elements. So kann die Effektivität des thermoelektrischen Elements gesteigert werden.

Ferner betrifft die vorliegende Erfindung einen Vakuumdämmkörper nach einer der vorstehend beschriebenen Varianten, bei dem das thermoelektrische Element in dem Freiraum zwischen den unterschiedlich dotierten Halbleiterelementen ein Material in Pulverform aufweist. Dieses Material in Pulverform ist dabei gleichzeitig auch ein Kernmaterial für den Vakuumdämmkörper. Somit kann nicht nur die Leistungsfähigkeit des thermoelektrischen Elements gesteigert werden, sondern auch gleichzeitig die mit dem Kernmaterial in Verbindung stehenden Vorteile erreicht werden. Dabei ist eine Kapselung des thermoelektrischen Elements von dem Kernmaterial aufgrund der Materialidentität nicht notwendig.

Zudem betrifft die vorliegende Erfindung ein Kühl- und/oder Gefriergerät mit wenigstens einem Korpus und mit wenigstens einem gekühlten Innenraum, der von dem Korpus umgeben ist sowie mit wenigstens einem Verschlusselement, mittels dessen der temperierte und vorzugsweise der gekühlte Innenraum verschließbar ist. Zwischen dem temperierten und vorzugsweise dem gekühlten Innenraum und der Außenwand des Behältnisses und vorzugsweise des Geräts befindet sich wenigstens ein Zwischenraum, in dem wenigstens ein Vakuumdämmkörper gemäß der Erfindung.

Der Vakuumdämmkörper kann sich zwischen der Außenseite und der Innenseite des Korpus in dem Innenbehälter und/oder zwischen der Außenseite und der Innenseite der Tür oder eines sonstigen Verschlusselementes befinden.

In einer bevorzugten Ausgestaltung des erfindungsgemäßen Behältnisses und vorzugsweise des erfindungsgemäßen Kühl- und/oder Gefriergeräts ist dieses teilweise oder vollständig mit Hilfe eines Vollvakuumsystems gedämmt. Hierbei handelt es sich um eine Anordnung, deren Wärmedämmung zwischen Außenseite und Innenraum am Korpus und/oder an dem Verschlusselement ausschließlich oder überwiegend aus einem evakuierten Element, insbesondere in Form der Umhüllung aus vakuumdichter Folie bzw. Hochbarrierefolie mit einem Kernmaterial handelt. Erfindungsgemäß wird die Vollvakuumdämmung durch einen oder mehrere Vakuumdämmkörper gebildet. Eine weitere Wärmedämmung durch einen Isolierschaum und/oder Vakuumisolationspaneele oder durch ein anderes Mittel zur Wärmdämmung zwischen Innen- und Außenseite des Gerätes ist vorzugsweise nicht vorgesehen.

Diese bevorzugte Art der Wärmedämmung in Form eines Vollvakuumsystems kann sich zwischen der den Innenraum begrenzenden Wand und der Außenhaut des Korpus und/oder zwischen der Innenseite und der Außenseite des Verschlusselementes, wie z.B. einer Tür, Klappe, Deckel oder dergleichen erstrecken.

Das Vollvakuumsystem kann so erhalten werden, dass eine Umhüllung aus einer gasdichten Folie mit einem Kernmaterial gefüllt und anschließend vakuumdicht versiegelt wird. In einer Ausführungsform erfolgt sowohl das Befüllen als auch das vakuumdichte Versiegeln der Umhüllung bei Normal- bzw. Umgebungsdruck. Die Evakuierung erfolgt dann durch Anschluss einer geeigneten in die Umhüllung eingearbeiteten Schnittstelle, beispielsweise eines Evakuierungsstutzens, der ein Ventil aufweisen kann, an eine Vakuumpumpe. Vorzugsweise herrscht während der Evakuierung außerhalb der Umhüllung Normal- bzw. Umgebungsdruck. Es ist in dieser Ausführungsform vorzugsweise zu keinem Zeitpunkt der Herstellung erforderlich, die Umhüllung in eine Vakuumkammer einzubringen. Insofern kann in einer Ausführungsform während der Herstellung der Vakuumdämmung auf eine Vakuumkammer verzichtet werden.

Erfindungsgemäß ist vorgesehen, dass es sich bei dem erfindungsgemäßen Behältnis um ein Kühl- und/oder Gefriergerät, insbesondere um ein Haushaltkältegerät bzw. ein gewerbliches Kühlgerät handelt. Beispielsweise sind solche Geräte umfasst, die für eine stationäre Anordnung im Haushalt, in einem Hotelzimmer, in einer gewerblichen Küche oder in einer Bar konzipiert sind. Beispielsweise kann es sich auch um einen Weinkühlschrank handeln. Ferner sind auch Kühl- und/oder Gefriertruhen von der Erfindung umfasst. Die erfindungsgemäßen Geräte können eine Schnittstelle zur Anbindung an eine Stromversorgung, insbesondere an ein Haushaltsstromnetz (z.B. einen Stecker) und/oder eine Steh- oder Einbauhilfe wie beispielsweise Stellfüße oder Schnittstelle zur Fixierung innerhalb einer Möbelnische aufweisen. Beispielsweise kann es sich bei dem Gerät um ein Einbaugerät oder auch um ein Standgerät handeln.

In einer Ausführungsform ist das Behältnis bzw. das Gerät derart ausgebildet, dass es mit einer Wechselspannung, wie beispielsweise mit einer Hausnetzspannung von z.B. 120 V und 60 Hz oder 230 V und 50 Hz betrieben werden kann. In einer alternativen Ausführungsform ist das Behältnis bzw. das Gerät derart ausgebildet, dass es mit Gleichstrom einer Spannung von beispielsweise 5 V, 12 V oder 24 V betrieben werden kann. In dieser Ausgestaltung kann vorgesehen sein, dass innerhalb oder außerhalb des Gerätes ein Steckernetzteil vorgesehen ist, über welches das Gerät betrieben wird. Ein Vorteil der Verwendung von thermoelektrischen Wärmepumpen ist in dieser Ausführungsform, dass die komplette EMV-Problematik lediglich am Netzteil auftritt.

Insbesondere kann vorgesehen sein, dass das Kühl- und/oder Gefriergerät eine schrankartige Gestalt hat und einen Nutzraum aufweist, der an seiner Vorderseite (im Falle einer Truhe an der Oberseite) für einen Benutzer zugänglich ist. Der Nutzraum kann in mehrere Kompartimente unterteilt sein, die alle bei derselben oder bei unterschiedlichen Temperaturen betrieben werden. Alternativ kann lediglich ein Kompartiment vorgesehen sein. Innerhalb des Nutzraumes bzw. eines Kompartiments können auch Lagerungshilfen wie beispielsweise Ablagefächer, Schubladen oder Flaschenhalter (im Falle einer Truhe auch Raumteiler) vorgesehen sein, um eine optimale Lagerung von Kühl- oder Gefriergütern und eine optimale Platzausnützung zu gewährleisten.

Der Nutzraum kann durch wenigstens eine um eine vertikale Achse schwenkbare Tür verschlossen sein. Im Falle einer Truhe ist eine um eine horizontale Achse schwenkbare Klappe oder ein Schiebedeckel als Verschlusselement denkbar. Die Tür oder ein sonstiges Verschlusselement kann im geschlossenen Zustand anhand einer umlaufenden Magnetdichtung mit dem Korpus im Wesentlichen luftdicht in Verbindung stehen. Vorzugsweise ist auch die Tür bzw. ein sonstiges Verschlusselement wärmeisoliert, wobei die Wärmeisolierung anhand einer Ausschäumung und ggf. anhand von Vakuumisolationspaneelen erreicht werden kann, oder auch vorzugsweise anhand eines Vakuumsystems und besonders bevorzugt anhand eines Vollvakuumsystems. An der Innenseite der Tür können ggf. Türabsteller vorgesehen sein, um auch dort Kühlgüter lagern zu können.

In einer Ausführungsform kann es sich um ein Kleingerät handeln. In derartigen Geräten weist der Nutzraum, der durch die Innenwand des Behälters definiert ist, beispielsweise ein Volumen von kleiner 0,5 m³, kleiner 0,4 m³ oder kleiner 0,3 m³ auf.

Die Außenabmessungen des Behälters bzw. Gerätes liegen vorzugsweise im Bereich bis 1 m hinsichtlich der Höhe, der Breite und der Tiefe.

Weitere Einzelheiten und Details werden anhand der nachfolgenden Figurenbeschreibung erläutert. Es zeigt:

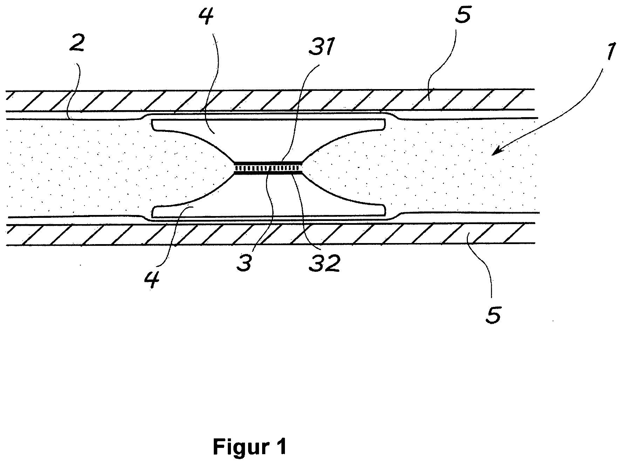

- Fig. 1:: eine Querschnittsansicht eines erfindungsgemäßen Vakuumdämmkörpers mit einem thermoelektrischen Element.

Fig. 1 zeigt einen Vakuumdämmkörper 1 dessen Vakuumbereich durch eine vakuumdichte Umhüllung 2 definiert, d.h. begrenzt ist. Vorzugsweise handelt es sich bei der Umhüllung 2 um eine Hochbarrierefolie.

Zudem erkennt man ein thermoelektrisches Element 3 mit Halbleiterpellets, die in der Zeichnung die beiden Wärmeleitkörper 4 verbinden bzw. sich zwischen diesen erstrecken. In einer zur Ausrichtung der Halbleiterpellets quer verlaufenden Richtung weist das thermoelektrische Element 3 zwei Flächen 31, 32 auf, zwischen denen ein Temperaturgefälle einstellbar ist. Um die an diesen Flächen 31, 32 herrschende Temperatur wirkungsvoll an Randbereiche der Umhüllung 2 zu transportieren, stehen die jeweiligen Wärmeleitkörper 4 sowohl mit der Umhüllung 2 als auch mit der Fläche 31, 32 des thermoelektrischen Elements 3 in Verbindung.

Die Wärmeleitkörper 4 weisen eine Querschnittsfläche auf, die sich ausgehend von dem thermoelektrischen Element 3 zu dem Rand des Vakuumdämmkörpers hin vergrößert.

Zudem erkennt man einen außerhalb des Vakuumbereichs angeordneten Wärmetauscher 5, der dazu ausgebildet ist, die durch den jeweiligen Wärmeleitkörper 4 transportierte Wärme aufzunehmen bzw. abzugeben.

Der Wärmeleitkörper 4 und der Wärmetauscher 5, d. h. der primäre 4 und der sekundäre Wärmetauscher 5 stehen wärmeleitend miteinander in Verbindung. Die Wärmeleitung erfolgt durch die dünne Folie hindurch. Es kann, wie in der Zeichnung dargestellt, vorgesehen sein, dass die Dicke der Folien 2 an Innen- und Außenseite im Bereich des Wärmetauschers 4 gegenüber den anderen Bereichen reduziert ist, um einen besseren Wärmetausch zu gewährleisten. Alternativ kann die Dicke der Folie 2 aber auch in diesem Bereich unverändert sein, was in der Produktion vorteilhaft ist und die Vakuumdichtigkeit des Systems erhöht.

Innerhalb des Vakuumdämmkörpers befindet sich Vakuum, so dass sich das thermoelektrische Element 3 und die primären Wärmetauscher 4 vollständig innerhalb des evakuierten Bereiches befinden.

Des Weiteren befindet sich innerhalb des evakuierten Bereiches zwischen den Folien ein Stützkern, beispielsweise im Form eines Pulvers und vorzugsweise in Form von Perlitpulver. Liegt dieses Pulver auch zwischen den Halbleiter-Pellets des Peltierelementes vor, wird dadurch sowohl die Gaswärmeleitung als auch der Strahlungswärmetausch zwischen warmer und kalter Seite des Peltierelementes bzw. des thermoelektrischen Elementes unterbunden.

## Patentansprüche

1. Kühl- und/oder Gefriergerät mit wenigstens einem Korpus und mit wenigstens einem gekühlten Innenraum, der von dem Korpus umgeben ist, sowie mit wenigstens einem Verschlusselement, mittels dessen der gekühlte Innenraum verschließbar ist, wobei sich zwischen dem gekühlten Innenraum und der Außenwand des Gerätes wenigstens ein Zwischenraum befindet, in dem wenigstens ein Vakuumdämmkörper (1) angeordnet ist, der eine Umhüllung (2) aufweist, die einen Vakuumbereich definiert,
**dadurch gekennzeichnet,**
**dass** innerhalb des Vakuumbereichs des Vakuumdämmkörpers (1) ein Peltierelement (3) und beidseitig damit in Kontakt stehende Wärmeleitkörper (4) angeordnet sind, wobei das Peltierelement (3) ausgebildet ist, einen Temperaturunterschied zwischen zwei gegenüberliegenden Bereichen an der Außenseite der Umhüllung (2) zu erzeugen, und wobei die Wärmeleitkörper (4) in einem wärmeleitenden Kontakt mit dem Peltierelement (3) und der Umhüllung (2) stehen.

2. Kühl- und/oder Gefriergerät nach Anspruch 1, **dadurch gekennzeichnet, dass** das Peltierelement (3) eine im Wesentlichen plattenartige Grundform und zwei Thermoflächen aufweist, die vorzugsweise zueinander in etwa parallel verlaufen und voneinander beabstandet sind.

3. Kühl- und/oder Gefriergerät nach Anspruch 1 oder 2, **dadurch gekennzeichnet, dass** die Wärmeleitkörper (4) in direktem Kontakt mit dem Peltierelement (3) und der Umhüllung (2) stehen.

4. Kühl- und/oder Gefriergerät nach Anspruch 3, **dadurch gekennzeichnet, dass** die Kontaktflächen zwischen den Wärmeleitkörpern (4) und der Umhüllung (2) größer als die Kontaktflächen zwischen den Wärmeleitkörpern (4) und dem Peltierelement (3) sind.

5. Kühl- und/oder Gefriergerät nach einem der vorhergehenden Ansprüche, **dadurch gekennzeichnet, dass** ferner ein Wärmetauscher vorgesehen ist, der außerhalb des Vakuumbereichs angeordnet und mit einem Bereich der Umhüllung (2) thermisch gekoppelt ist, vorzugsweise mit einem Bereich, der durch das Peltierelement (3) in seiner Temperatur beeinflussbar ist.

6. Kühl- und/oder Gefriergerät nach einem der vorhergehenden Ansprüche, **dadurch gekennzeichnet, dass** sich in dem Vakuumbereich ferner ein Kernmaterial, insbesondere Perlit befindet.

7. Kühl- und/oder Gefriergerät nach einem der vorhergehenden Ansprüche, **dadurch gekennzeichnet, dass** das Peltierelement (3) ein n-dotiertes Halbleiterelement und ein p-dotiertes Halbleiterelement umfasst, das über eine Leiterbrücke mit dem n-dotierten Halbleiterelement verbunden ist, wobei die beiden Halbleiterelemente voneinander beabstandet sind, so dass zwischen ihnen ein Freiraum gebildet ist, und der Freiraum zwischen dem n-dotierten Halbleiterelement und dem p-dotierten Halbleiterelement mit einem Material in Pulverform gefüllt ist, wobei vorzugsweise vorgesehen ist, dass das Material in Pulverform eine mittlere Korngröße eines Pulverkorns aufweist, die zwischen 5 µm und 30 µm, bevorzugterweise zwischen 10 µm und 25 µm, und besonders bevorzugterweise zwischen 15 µm und 20 µm, liegt.

8. Kühl- und/oder Gefriergerät nach Anspruch 7, **dadurch gekennzeichnet, dass** das Material in Pulverform gleichzeitig ein Kernmaterial des Vakuumdämmkörpers (1) ist.

## Claims

1. Refrigerator and/or freezer comprising at least one body and comprising at least one cooled interior, which is surrounded by the body, and comprising at least one closure element, by means of which the cooled interior can be closed, wherein at least one space is located between the cooled interior and the outer wall of the appliance, in which at least one vacuum insulation body (1) is arranged which comprises a covering (2) which defines a vacuum region,
**characterised in that**
a Peltier element (3) and thermally conductive bodies (4) that are in contact therewith on either side are arranged inside the vacuum region of the vacuum insulation body (1), wherein the Peltier element (3) is designed to generate a temperature difference between two opposing regions on the outside of the covering (2), and the thermally conductive bodies (4) are in thermally conductive contact with the Peltier element (3) and the covering (2).

2. Refrigerator and/or freezer according to claim 1, **characterised in that** the Peltier element (3) has a substantially planar basic shape and two thermal surfaces, which preferably extend approximately in parallel with one another and are spaced apart from one another.

3. Refrigerator and/or freezer according to claim 1 or 2, **characterised in that** the thermally conductive bodies (4) are in direct contact with the Peltier element (3) and the covering (2).

4. Refrigerator and/or freezer according to claim 3, **characterised in that** the contact surfaces between the thermally conductive bodies (4) and the covering (2) are larger than the contact surfaces between the thermally conductive bodies (4) and the Peltier element (3).

5. Refrigerator and/or freezer according to any of the preceding claims, **characterised in that** a heat exchanger is also provided, which is arranged outside the vacuum region and is thermally coupled to a region of the covering (2), preferably to a region of which the temperature can be influenced by the Peltier element (3).

6. Refrigerator and/or freezer according to any of the preceding claims, **characterised in that** a core material, in particular perlite, is also positioned in the vacuum region.

7. Refrigerator and/or freezer according to any of the preceding claims, **characterised in that** the Peltier element (3) comprises an n-doped semiconductor element and a p-doped semiconductor element, which is connected to the n-doped semiconductor element by a conductor bridge, wherein the two semiconductor elements are spaced apart from one another such that a free space is formed therebetween, and the free space between the n-doped semiconductor element and the p-doped semiconductor element is filled with a material in powder form, wherein it is preferably provided that the material in powder form has an average particle size of between 5 µm and 30 µm, preferably of between 10 µm and 25 µm, and particularly preferably of between 15 µm and 20 µm.

8. Refrigerator and/or freezer according to claim 7, **characterised in that** the material in powder form is simultaneously a core material of the vacuum insulation body (1).

## Revendications

1. Appareil de réfrigération et/ou de congélation avec au moins un corps et avec au moins un espace intérieur réfrigéré, qui est entouré par le corps, ainsi qu'avec au moins un élément de fermeture, au moyen duquel l'espace intérieur réfrigéré peut être fermé, dans lequel se trouve, entre l'espace intérieur réfrigéré et la paroi extérieure de l'appareil, au moins un espace intermédiaire, dans lequel est disposé au moins un corps d'isolation sous vide (1), qui présente une gaine (2), qui définit une zone sous vide,
**caractérisé en ce que**
sont disposés, à l'intérieur de la zone sous vide du corps d'isolation sous vide (1), un élément Peltier (3) et des corps thermoconducteurs (4) en contact avec celui-ci de part et d'autre, dans lequel l'élément Peltier (3) est réalisé pour générer une différence de température entre deux zones se faisant face au niveau du côté extérieur de la gaine (2), et dans lequel les corps thermoconducteurs (4) sont en contact thermoconducteur avec l'élément Peltier (3) et la gaine (2).

2. Appareil de réfrigération et/ou de congélation selon la revendication 1, **caractérisé en ce que** l'élément Peltier (3) présente une forme de base de type sensiblement plaque et présente deux faces thermiques, qui s'étendent de préférence à peu près de manière parallèle l'une par rapport à l'autre et sont tenues à distance l'une de l'autre.

3. Appareil de réfrigération et/ou de congélation selon la revendication 1 ou 2, **caractérisé en ce que** les corps thermoconducteurs (4) sont en contact direct avec l'élément Peltier (3) et la gaine (2).

4. Appareil de réfrigération et/ou de congélation selon la revendication 3, **caractérisé en ce que** les faces de contact entre les corps thermoconducteurs (4) et la gaine (2) sont plus grandes que les faces de contact entre les corps thermoconducteurs (4) et l'élément Peltier (3).

5. Appareil de réfrigération et/ou de congélation selon l'une quelconque des revendications précédentes, **caractérisé en ce qu'**est prévu en outre un échangeur de chaleur, qui est disposé à l'extérieur de la zone sous vide et est couplé de manière thermique à une zone de la gaine (2), de préférence à une zone, dont la température peut être influencée par l'élément Peltier (3).

6. Appareil de réfrigération et/ou de congélation selon l'une quelconque des revendications précédentes, **caractérisé en ce que** se trouve dans la zone sous vide en outre un matériau central, en particulier de la perlite.

7. Appareil de réfrigération et/ou de congélation selon l'une quelconque des revendications précédentes, **caractérisé en ce que** l'élément Peltier (3) comprend un élément à semi-conducteurs dopé n et un élément à semi-conducteurs dopé p, qui est relié à l'élément à semi-conducteurs dopé n par l'intermédiaire d'un pont conducteur, dans lequel les deux éléments à semi-conducteurs sont tenus à distance l'un de l'autre de sorte qu'est formé entre eux un espace libre, et l'espace libre est rempli d'un matériau sous forme pulvérulente entre l'élément à semi-conducteurs dopé n et l'élément à semi-conducteurs dopé p, dans lequel il est prévu de préférence que le matériau sous forme pulvérulente présente une granulométrie moyenne d'un grain de poudre, qui est comprise entre 5 µm et 30 µm, de manière préférée entre 10 µm et 25 µm, de manière particulièrement préférée entre 15 µm et 20 µm.

8. Appareil de réfrigération et/ou de congélation selon la revendication 7, **caractérisé en ce que** le matériau sous forme pulvérulente est dans le même temps un matériau central du corps d'isolation sous vide (1).
